# DEMANDE DE BREVET EUROPEEN

(11) **EP 4 742 861 A1**
(43) Date de publication de la demande: **13.05.2026**
(21) Numéro de dépôt: 25211561.3
(22) Date de dépôt: 28.10.2025
(51) Int. Cl.: H10F 30/225

(54) **DISPOSITIF ÉLECTRONIQUE**

(30) Priorité: 08.11.2024 FR 2412224
(71) Demandeur: STMicroelectronics International N.V., 1228 Plan-les-Ouates, Geneva (CH)
(72) Inventeur: BIANCHI, Raul Andres, 73800 MYANS (FR); PLACE, Sebastien, 38410 VAULNAVEYS LE BAS (FR); BUJ, Christel Marie-Noëlle, 38054 GRENOBLE CEDEX (FR); GOLANSKI, Dominique, 38610 GIERES (FR); NICHOLSON, Isobel, EDINBURGH EH11 1EQ (GB)
(74) Mandataire: Cabinet Beaumont

(57) **Abrégé**

La présente description concerne un dispositif électronique comprenant une diode à avalanche à photon unique (22), la diode à avalanche à photon unique (22) comprenant une jonction PN (26-28a), la jonction PN ayant une première dimension (R) inférieure à 1,2 µm, la diode à avalanche à photon unique (22) étant entourée d'un mur isolant (30), la première dimension (R) étant la plus petite dimension de la jonction.

## Description

### Domaine technique

La présente description concerne de façon générale concerne de façon générale les dispositifs électroniques et, en particulier, les dispositifs électroniques comprenant des diodes à avalanche à photon unique et leur procédé de fabrication.

### Technique antérieure

Une diode à avalanche à photon unique (SPAD) est un photodétecteur à l'état solide de la même famille que les photodiodes et les photodiodes à avalanche (APD), tout en étant fondamentalement liée aux comportements de base des diodes. Comme pour les photodiodes et les APD, une SPAD est basée sur une jonction PN semiconductrice qui peut être éclairée par un rayonnement ionisant. La différence fondamentale entre les SPAD et les APD ou les photodiodes est qu'une SPAD est polarisée bien au-delà de sa tension de claquage en polarisation inverse et présente une structure qui permet un fonctionnement sans dommage ni bruit excessif.

### Résumé de l'invention

Un mode de réalisation prévoit un dispositif électronique comprenant une diode à avalanche à photon unique, la diode à avalanche à photon unique comprenant une jonction PN, la jonction PN ayant une première dimension inférieure à 1,2 µm, la diode à avalanche à photon unique étant entourée d'un mur isolant, la première dimension étant la plus petite dimension de la jonction.

Un autre mode de réalisation prévoit un procédé de fabrication d'un dispositif électronique comprenant une diode à avalanche à photon unique, la diode à avalanche à photon unique comprenant une jonction PN, le procédé comprenant une étape de dopage pour fabriquer au moins une partie de l'anode de la diode à avalanche à photon unique, la jonction PN ayant une première dimension inférieure à 1,2 µm, la diode à avalanche à photon unique étant entourée d'un mur isolant, la première dimension étant la plus petite dimension de la jonction.

Selon un mode de réalisation, le mur isolant comprend un coeur conducteur et une gaine isolante.

Selon un mode de réalisation, la cathode de la diode à avalanche à photon unique comprend une région dopée N située dans un substrat, l'anode de la diode à avalanche à photon unique comprenant : - une première partie située à l'aplomb de la cathode ; et - une deuxième partie entourant une région du substrat, ladite région du substrat étant séparée de la cathode par la première partie.

Selon un mode de réalisation, la jonction PN est formée par la première partie de l'anode, la cathode et la portion du substrat située entre la première partie de l'anode et la cathode.

Selon un mode de réalisation, une deuxième dimension est inférieure à 0,5 µm, la deuxième dimension étant la plus petite dimension du chevauchement entre la première partie et la deuxième partie.

Selon un mode de réalisation, la première dimension est inférieure à 150 %, par exemple inférieure à 130 %, de la résolution spatiale latérale du procédé de dopage utilisé pour former au moins une partie de l'anode de la diode à avalanche à photon unique.

Selon un mode de réalisation, le procédé de dopage utilisé est une implantation ionique d'éléments dopants.

Selon un mode de réalisation, la première dimension est supérieure à 90 % de la résolution spatiale latérale du procédé de dopage.

Selon un mode de réalisation, la résolution spatiale latérale d'un procédé de dopage est, pendant le dopage d'une région ayant la forme d'un parallélépipède rectangle, la plus petite valeur de la plus petite dimension de la face supérieure de la région permettant à la face supérieure de la région d'être plane.

Selon un mode de réalisation, la première dimension est inférieure à 1 µm.

Selon un mode de réalisation, la première dimension est comprise entre 0,7 µm et 1,2 µm.

Selon un mode de réalisation, le dispositif comprend un dispositif à temps de vol, la diode à avalanche à photon unique faisant partie du dispositif à temps de vol.

Selon un mode de réalisation, le procédé comprend la formation d'un masque dur, le masque dur comprenant une ouverture, au moins une des dimensions de l'ouverture étant inférieure à 150 % de la résolution spatiale latérale du procédé de dopage.

Selon un mode de réalisation, le dopage est effectué à partir de la face la plus proche de la cathode.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente la définition de la résolution spatiale latérale du dopage ;
la figure 2 représente un mode de réalisation d'un dispositif électronique comprenant une diode à avalanche à photon unique ;
la figure 3 représente un exemple de probabilités de claquage dans différentes diodes à avalanche à photon unique ; et
la figure 4 représente un mode de réalisation d'un dispositif électronique comprenant une diode à avalanche à photon unique.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou 10° près, de préférence à 5 % ou 5° près.

Le dispositif est par exemple destiné à l'industrie automobile. La tendance à la conduite autonome génère une demande croissante de capteurs de télémétrie 3D. Ces capteurs sont par exemple des LIDAR à SPAD capables de générer des images et des vidéos en 3D. Ces capteurs comprennent par exemple la technologie d'imagerie de profondeur "Temps de Vol" combinée à la technologie standard d'imagerie d'intensité 2D. En effet, la technologie de matrice de SPAD est capable de produire les deux.

Le dispositif peut par exemple être utilisé dans le domaine industriel. La reconnaissance et la manipulation d'objets par des robots industriels génèrent une demande croissante de capteurs de télémétrie 3D, tels que les LIDAR à SPAD.

Le dispositif est par exemple destiné à être utilisé dans l'électronique personnelle. La reconnaissance faciale et les caméras autofocus sophistiquées des smartphones et autres appareils électroniques grand public augmentent la demande de capteurs de télémétrie 3D, tels que les LIDAR à SPAD.

Le dispositif est par exemple destiné à être utilisé dans des équipements de communication, ou dans des ordinateurs et des périphériques. Par exemple, les détecteurs photoniques ou les dispositifs de communication optique intègrent des capteurs à SPAD pour leur grande sensibilité, leur précision corrélée au temps et le signal de sortie puissant dû à la multiplication de la porteuse par avalanche.

Le dispositif divulgué comprend un transistor de type HEMT. Les transistors de type HEMT sont généralement utilisés dans des applications à haute fréquence et à haute puissance telles que les communications par satellite, les systèmes radar et les amplificateurs à micro-ondes. Les transistors de type HEMT peuvent également être utilisés dans certains dispositifs électroniques personnels spécialisés tels que des amplificateurs audio haut de gamme ou des émetteurs de radiofréquences (RF). Les transistors de type HEMT sont de plus en plus utilisés dans l'électrification des voitures, en particulier dans les véhicules électriques et hybrides. Les transistors de type HEMT sont utilisés en électronique de puissance pour commander le flux d'énergie électrique dans les équipements industriels tels que les moteurs, les générateurs et les transformateurs. Les transistors de type HEMT sont utilisés dans les systèmes d'éclairage à LED (de l'anglais Light Emitting Diode, diode électroluminescente) pour commander le courant et la tension. Les transistors de type HEMT contribuent à améliorer l'efficacité et les performances des systèmes d'éclairage à LED. Les transistors de type HEMT sont utilisés dans les systèmes d'éclairage à LED (de l'anglais Light Emitting Diode, diode électroluminescente) pour commander le courant et la tension. Les transistors de type HEMT contribuent à améliorer l'efficacité et les performances des systèmes d'éclairage à LED.

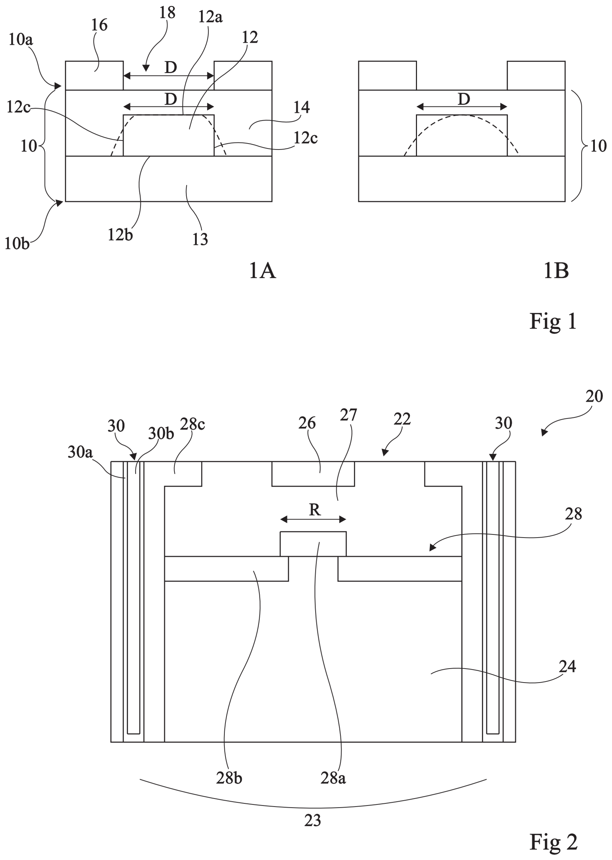

La figure 1 représente la définition de la résolution spatiale latérale d'un procédé de dopage. Plus particulièrement, la figure 1 comprend une vue 1A, représentant le cas où la dimension D d'une structure dopée est supérieure à la résolution spatiale latérale du procédé de dopage utilisé, et une vue 1B, représentant le cas où la dimension D d'une structure dopée est inférieure à la résolution spatiale latérale du procédé de dopage utilisé.

Les vues 1A et 1B représentent un substrat semiconducteur 10. Le substrat 10 comprend une face supérieure 10a et une face inférieure 10b, opposée à la face supérieure 10a. On souhaite former une région dopée 12 (en trait plein) dans le substrat 10 à l'aide du procédé de dopage. Le procédé de dopage est par exemple une implantation ionique d'éléments dopants. Le procédé de dopage est mis en œuvre du côté de la face supérieure 10a.

La région 12 a, dans les vues 1A et 1B, une forme rectangulaire. La région 12 présente donc, dans les vues 1A et 1B, un côté supérieur 12a, en d'autres termes le côté le plus proche de la face supérieure 10a, un côté inférieur 12b, en d'autres termes le côté le plus proche de la face inférieure 10b, et deux côtés latéraux 12c, reliant les côtés supérieur et inférieur. Les côtés supérieur et inférieur sont parallèles l'un à l'autre. Le côté supérieur est parallèle à la face supérieure du substrat 10. Les côtés latéraux sont perpendiculaires aux côtés supérieur et inférieur de la région 12.

La région 12 est un parallélépipède rectangle. Les vues 1A et 1B correspondent à une vue de la région 12 parallèle à une face du parallélépipède rectangle.

La région 12 est une région enterrée. La région 12 est donc entourée de tous côtés par une portion du substrat 10. La région 12, et plus précisément le côté inférieur de la région 12, est, dans l'exemple de la figure 1, séparée de la face inférieure 10b par une région 13. La région 12, et plus précisément le côté supérieur de la région 12, est séparée de la face supérieure 10a par une région 14. La région 12, et plus précisément les côtés latéraux de la région 12, est séparée des parois latérales du substrat par des portions de la région 14. Il est souhaitable que la région 12 soit clairement distincte de la région 14.

La région 13 est par exemple une région dopée. La région 13 est par exemple dopée du même type de conductivité que la région utile 12. La région 14 est par exemple soit non dopée, soit dopée d'un type de conductivité opposé au type de conductivité de la région 13. Ni la région 13, ni la région 14 ne sont dopées par l'étape de dopage formant la région 12.

La région 13 est entièrement située entre la région 12 et la face inférieure 10b. Par conséquent, il n'y a aucune portion de la région 13 entre les côtés latéraux de la région 12 et les parois latérales du substrat 10. Par exemple, la face supérieure de la région 13 est parallèle et en contact avec le côté inférieur de la région 12.

La dimension D correspond à la longueur de la région 12 dans le plan des vues 1A et 1B de la figure 1. La dimension D correspond à la largeur de la portion de la face supérieure de la région 12 la plus proche de la face supérieure du substrat 10. La dimension D correspond à la largeur du parallélépipède rectangle formant la région 12. La dimension D correspond à la plus petite distance entre deux parois latérales opposées de la région rectangulaire 12.

Le procédé de dopage peut comporter la formation d'un masque dur 16 comprenant une ouverture 18. L'ouverture est alors située à l'aplomb de l'emplacement de la région 12. L'ouverture 18 a des dimensions, dans un plan parallèle au plan de la face supérieure du substrat, identiques aux dimensions de la région 12. Dans le cas d'un tel procédé de dopage, la dimension D correspond à la dimension de l'ouverture 18 correspondant à la dimension D de la région 12.

Les lignes en traits pointillées des vues 1A et 1B de la figure 1 correspondent aux côtés supérieur et latéraux de la région 12 obtenue par le procédé de dopage lorsque l'on essaie de former la région 12 représentée en trait plein.

La résolution spatiale latérale d'un procédé de dopage est la plus petite dimension D permettant la formation d'une région 12 avec une face supérieure plane. Dans la vue A, la dimension D est supérieure à la valeur de la résolution du procédé de dopage utilisée. Dans la vue B de la figure 1, la dimension D est inférieure à la valeur de la résolution du procédé de dopage utilisée. Par conséquent, la région formée 12 comprend une face supérieure incurvée, sans aucune portion plane.

Selon une variante, si le procédé de dopage est utilisé pour former une région dopée 14, les régions 12 et 13 étant par exemple non dopées, dopées avec un type de conductivité différent de celui de la région 14, ou dopées plus faiblement que ce qui est souhaité pour la région 14, le procédé de dopage comprend par exemple une première séquence d'une photolithographie et d'une implantation de dopants pour la partie de la région 14 au-dessus de la région 12 et une deuxième séquence d'une photolithographie et d'une implantation de dopants pour la partie de la région 14 sur les côtés de la région 12. Dans la première séquence, l'ouverture du masque est telle qu'illustrée en figure 1. Dans la deuxième séquence, le masque est situé au-dessus de la région 12 et les ouvertures sont à l'emplacement du masque dans la figure 1. Dans ce cas, la résolution spatiale latérale d'un procédé de dopage est définie comme la plus petite dimension D permettant la formation d'une région 14 où l'interface avec la face supérieure 12a de la région 12 est plane.

Par exemple, le procédé de dopage est un procédé d'implantation ionique, auquel cas la résolution spatiale latérale est proportionnelle à la profondeur de l'implantation. Le procédé de dopage peut également être l'implantation de dopants par recuit thermique, auquel cas la résolution spatiale latérale est accrue en raison de la diffusion des dopants pendant le recuit.

La figure 2 représente un mode de réalisation d'un dispositif électronique 20 comprenant une diode à avalanche à photon unique (SPAD) 22. Plus particulièrement, la figure 2 représente la SPAD 22 faisant partie d'un pixel 23. La SPAD fait par exemple partie d'un dispositif de télémétrie du temps de vol compris dans le dispositif 20.

La figure 2 représente un substrat 24 du dispositif 20, sur et dans lequel la SPAD 22 est formée. Le substrat 24 est un substrat semiconducteur, par exemple en silicium. Par exemple, un circuit d'extinction associé à la SPAD 22 est formé dans et sur un autre substrat.

Le dispositif 20 comprend par exemple une pluralité de pixels, ou circuits, 23. Par exemple, les pixels 23 sont disposés selon le motif d'une matrice.

Chaque SPAD 22 comprend une cathode 26 et une anode 28. L'anode 28 comprend une région 28a, une région 28b et une région 28c.

La cathode 26 est une région semiconductrice dopée N. La cathode 26 déborde par exemple sur la face supérieure du substrat 24. En d'autres termes, la face supérieure de la cathode 26 est coplanaire avec la face supérieure du substrat 24. La cathode 26 a par exemple une forme cylindrique. Par exemple, la cathode 26 a, en vue de dessus, une forme circulaire. En d'autres termes, la face supérieure de la cathode 26 a une forme circulaire. Selon une variante, la cathode 26 a, en vue de dessus, la forme d'un rectangle, de préférence d'un carré, aux angles adoucis. La cathode 26 a de préférence une concentration de dopage sensiblement constante.

La région 28a est une région semiconductrice dopée P. La région 28a est par exemple enterrée dans le substrat 24. La région 28a a une face supérieure plane, par exemple sensiblement plane. La région 28a a, par exemple, une forme cylindrique. Par exemple, la région 28a a, en vue de dessus, une forme circulaire. En d'autres termes, la face supérieure de la région 28a a une forme circulaire. Selon une variante, la région 28a a, en vue de dessus, la forme d'un rectangle, de préférence d'un carré, aux angles adoucis. La région 28a est par exemple située sous la cathode 26. En d'autres termes, au moins une partie de la région 28a est alignée verticalement sur une partie de la cathode 26. Dans l'exemple de la figure 2, la région 28a est séparée de la cathode 26 par une portion du substrat 24. De préférence, la région 28a a des dimensions horizontales inférieures à celles de la cathode 26. La région 28a est par exemple séparée de la cathode 26 par une portion 27 du substrat 24, qui ne fait pas partie de la cathode ou de l'anode de la SPAD. Ladite portion est de préférence dopée de type N et a une concentration de dopage inférieure à la concentration de dopage de la région 28a et de la cathode 26, de préférence au moins 100 fois inférieure. La région 28a, la cathode 26 et la portion 27 du substrat située entre la région 28a et la cathode 26 forment la jonction PIN, de la SPAD.

Selon une variante, La région 28a et la cathode 26 peuvent être en contact. La région 28a et la cathode 26 ne sont alors pas séparées par une portion du substrat 24. De préférence, la face supérieure de la région 28a est alors entièrement en contact avec la cathode 26. Dans ce cas, la région 28a et la cathode 26 forment une PN jonction de la SPAD.

La région 28b est une région semiconductrice dopée p. La région 28b est par exemple enterrée dans le substrat 24. La région 28b est de préférence située sous la région 28a. En d'autres termes, la région 28a est de préférence située entre la région 28b et la cathode 26. La région 28b a par exemple la forme d'un anneau. La région 28b entoure latéralement une portion du substrat 24 alignée verticalement sur la région 28a. La région 28b et la région 28a sont de préférence en contact. Une partie de la face supérieure de la région 28b est de préférence en contact avec la face inférieure de la région 28a. Il y a donc un chevauchement vertical entre les régions 28a et 28b. Le chevauchement garantit la continuité électrique de l'anode.

De préférence, le chevauchement entre la région 28a et la région 28b est inférieur à 0,5 µm, par exemple inférieur à 0,1 µm. Le chevauchement est par exemple formé par la dispersion du motif de dopage pendant les étapes de dopage.

L'existence d'un chevauchement de ces deux régions 28a et 28b supérieur à 0,5 µm entraînerait la formation d'une région autour de l'interface entre les régions 28a et 28b avec un dopage P accru (par rapport aux régions 28a et 28b prises individuellement). Cela rendrait la SPAD plus sensible à la barrière de potentiel. Pour garantir que la barrière de potentiel n'impacte pas l'efficacité de la SPAD, il faudrait que l'intensité du dopage P soit réduite. Le gradient de dopage dans la jonction, qui est le facteur clef du maximum de champ électrique, serait diminué.

La région 28c est une région semiconductrice dopée P. La région 28c s'étend verticalement dans le substrat 24. La région 28c s'étend depuis la face supérieure du substrat 24 au moins jusqu'au niveau de la région 28b. Les régions 28b et 28c sont en contact, par exemple latéralement. La face supérieure de la région 28c est par exemple coplanaire avec la face supérieure du substrat 24. La largeur de la région 28c est par exemple plus grande au niveau de la face supérieure du substrat qu'au niveau de la région 28b. Par exemple, la région 28c comprend une partie supérieure ayant une première largeur, de préférence sensiblement constante, et une partie inférieure ayant une deuxième largeur, de préférence sensiblement constante. La deuxième largeur est par exemple inférieure à la première largeur. La région 28c a, en vue de dessus, la forme d'un anneau. La région 28c entoure la cathode 26 et les régions 28a et 28b. La région 28c est séparée de la cathode 26 par une portion du substrat 24.

Chaque région 28a, 28b, 28c a de préférence une concentration en dopants sensiblement constante. La concentration en dopants de la région 28a est par exemple supérieure à la concentration en dopants de la région 28b. La concentration en dopants dans la région 28b est par exemple inférieure à la concentration en dopants dans la région 28c.

Chaque SPAD est entourée d'un mur électriquement isolant 30. De préférence, les murs 30 entourant les différentes SPAD ont les mêmes dimensions.

De préférence, le mur 30 s'étend verticalement sur toute la hauteur de la SPAD correspondante. De préférence, le mur 30 s'étend, verticalement, au moins depuis le point de la cathode 26 et de l'anode 28 le plus proche de la face supérieure du substrat jusqu'au point de la cathode 26 et de l'anode 28 le plus éloigné de la face supérieure du substrat. En d'autres termes, dans l'exemple de la figure 2, le mur 30 s'étend, verticalement, au moins depuis la face supérieure de la cathode, correspondant à la face supérieure du substrat et à la face supérieure de la région 28c, jusqu'à la face inférieure de la région 28c, correspondant par exemple à la face inférieure du substrat 24.

Chaque mur 30 entoure latéralement la SPAD correspondante. En d'autres termes, chaque SPAD est, de préférence entièrement, séparée de la SPAD voisine par une partie du mur 30. Dans l'exemple de la figure 2, chaque SPAD est entourée d'un mur 30 associée à ladite SPAD et distincte des murs30 entourant l'autre SPAD. Par conséquent, deux SPAD voisines sont séparées par des portions de deux murs différents. Dans l'exemple de la figure 2, les différents murs entourant les différentes SPAD ne sont pas en contact. En d'autres termes, les différents murs entourant les différentes SPAD sont séparées les unes des autres par des portions du substrat 24.

De préférence, les murs 30 sont optiquement isolants. Les murs 30 sont par exemple du type isolation en tranchée profonde sur la face arrière (BDTI). Les murs 30 comprennent par exemple une gaine 30a en un matériau électriquement isolant, par exemple en oxyde de silicium ou en nitrure de silicium, et un coeur 30b en un matériau optiquement isolant, par exemple en métal. Par matériau optiquement isolant, on entend un matériau au moins partiellement opaque, de préférence entièrement opaque, à la longueur d'onde de travail de la SPAD, par exemple toutes les longueurs d'onde du domaine visible et/ou toutes les longueurs d'onde du domaine infrarouge proche. Les murs 30 sont par exemple configurés pour être polarisés. Plus particulièrement, le coeur conducteur des murs 30 est polarisé, par exemple par une tension négative, de sorte que le substrat semiconducteur 24 dans le pixel soit déplété, par exemple entièrement déplété.

La région 28a a une dimension R. La dimension R correspond à la plus petite dimension horizontale de la face supérieure plane de la région 28a. Si la région 28a a, en vue de dessus, la forme d'un disque, la dimension R correspond au diamètre du disque. Si la région 28a a, en vue de dessus, la forme d'un rectangle, la dimension R correspond à la plus petite dimension du rectangle, en d'autres termes la largeur.

Afin de maximiser la probabilité de claquage de la SPAD, la dimension R est configurée pour être aussi petite que possible afin de générer un seul point chaud. En pratique, la dimension R est configurée pour être inférieure ou égale à 150 % de la résolution spatiale latérale du procédé de dopage utilisé pour former la région 28a, de préférence inférieure ou égale à 130 % de la résolution spatiale latérale du procédé de dopage utilisé pour former la région 28a. De préférence, la dimension R est inférieure à 1,2 µm, par exemple entre 0,7 µm et 1,2 µm, par exemple inférieure à 1 µm. La dimension R est indépendante des dimensions de la SPAD, donc indépendante des dimensions de la cathode 26. La dimension R est supérieure à la résolution spatiale latérale du procédé de dopage utilisé pour former la région 28a de sorte à obtenir les profils de dopage souhaités.

Comme la jonction PN de la SPAD est située entre la région 28a et la cathode 26, les plus petites dimensions de la jonction PN sont par exemple inférieures ou égales à 150 % de la résolution spatiale latérale du procédé de dopage utilisé pour former la région 28a, de préférence inférieures ou égales à 130 % de la résolution spatiale latérale du procédé de dopage utilisé pour former la région 28a.

Le procédé de fabrication de la SPAD comprend :
a) le dopage du substrat 24 ;
b) le dopage du substrat afin de former les régions 28b ;
b) le dopage du substrat afin de former la région 28a ;
c) le dopage du substrat afin de former la région 28c ;
d) la formation des murs 30 ; et
e) le dopage du substrat afin de former la cathode 26.

Par exemple, l'étape c) comprend la formation d'un masque dur, non représenté, sur la face supérieure du substrat, le masque dur comprenant une ouverture au-dessus de la localisation de la région 28a. L'étape de dopage est mise en œuvre à travers l'ouverture du masque dur. L'ouverture est de préférence de forme rectangulaire, en vue de dessus. De préférence, au moins une des dimensions horizontales de l'ouverture, par exemple la longueur ou la largeur, est inférieure ou égale à 150 % de la résolution spatiale latérale du procédé de dopage utilisée pour former la région 28a, de préférence inférieure ou égale à 130 % de la résolution spatiale latérale du procédé de dopage utilisé pour former la région 28a.

Dans les mises en œuvre précédentes des SPAD, les SPAD étaient séparées et isolées les unes des autres par des jonctions semiconductrices, par exemple des jonctions PN. Dans ce type de structure, il était jugé nécessaire de veiller à ce que la jonction PN entre la cathode et l'anode soit la plus grande possible afin d'obtenir une uniformité du champ électrique dans la SPAD et un facteur de remplissage maximal entre la zone de jonction de la SPAD et la zone totale. Dans les SPAD actuelles, les fabricants ont continué à essayer d'obtenir des SPAD avec une grande jonction PN entre la cathode et l'anode. Par exemple, il est courant que les SPAD actuelles aient une dimension R correspondant aux quatre cinquièmes de la largeur de la SPAD.

Cependant, les inventeurs ont découvert qu'en présence de murs isolants telles que les murs 30 de la figure 2, en même temps que la taille de la jonction réduit, un effet d'entonnoir du champ électrique dans la jonction PN apparaît, ce qui est bénéfique pour la probabilité de claquage. L'effet d'entonnoir collecte et conduit les électrons photogénérés vers un petit point chaud central dans la jonction PN formée par la cathode et l'anode.

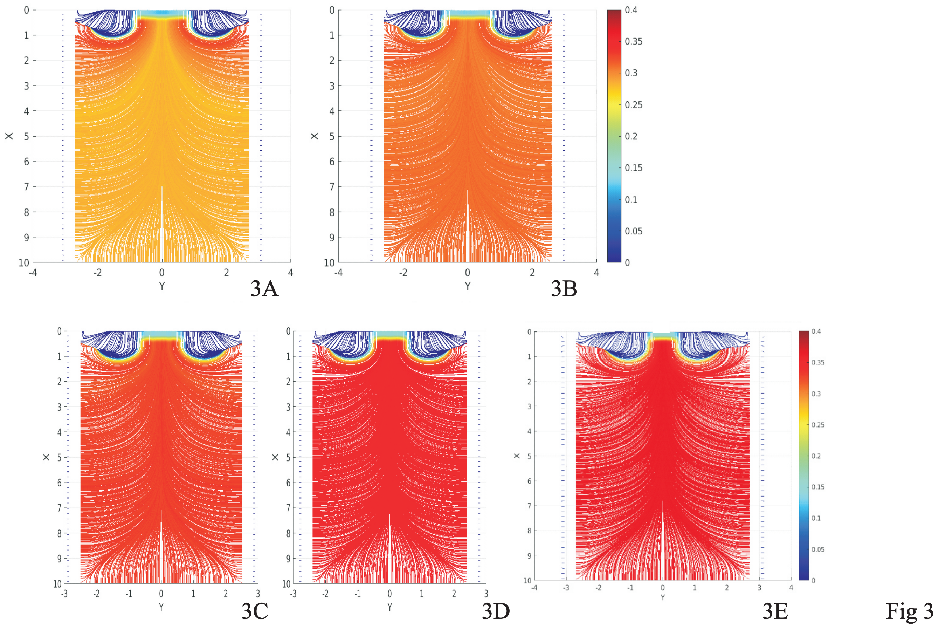

La figure 3 représente des exemples de probabilités de claquage dans différentes diodes à avalanche à photon unique. La figure 3 comprend cinq vues 3A, 3B, 3C, 3D, 3E représentant les probabilités de claquage dans des SPAD telles que la SPAD de la figure 2 ayant différentes valeurs de la dimension R. La dimension R est la seule différence entre les SPAD des vues 3A, 3B, 3C, 3D, 3E.

La dimension R de la SPAD de la vue 3A est supérieure à la dimension R de la SPAD de la vue 3B. La dimension R de la SPAD de la vue 3B est supérieure à la dimension R de la SPAD de la vue 3C. La dimension R de la SPAD de la vue 3C est supérieure à la dimension R de la SPAD de la vue 3D. La dimension R de la SPAD de la vue 3D est supérieure à la dimension R de la SPAD de la vue 3E. Par ailleurs, les valeurs de la dimension R de la SPAD des vues 3A à 3D sont supérieures à la résolution spatiale latérale du procédé de dopage utilisé pour former l'anode de la SPAD. La valeur de la dimension R de la SPAD de la vue 3E est la plus proche de la résolution spatiale latérale du procédé de dopage utilisé pour former l'anode de la SPAD.

On notera que, entre les vues 3A et 3D, la diminution de la valeur de la dimension R entraîne une augmentation des probabilités de claquage dans l'ensemble de la SPAD. Cet effet est particulièrement visible si la valeur de la dimension R est inférieure à 150 % de la résolution spatiale latérale du procédé de dopage utilisé pour former l'anode, et encore plus si la valeur de la dimension R est inférieure à 130 % de la résolution spatiale latérale du procédé de dopage utilisée pour former l'anode. Par ailleurs, il est visible que dans la vue 3E, où la dimension R est inférieure à la résolution spatiale latérale, la probabilité de claquage cesse de s'améliorer, diminue autour de la région 28a. Les inventeurs ont déterminé que cette diminution est due à un brouillage du motif de dopage.

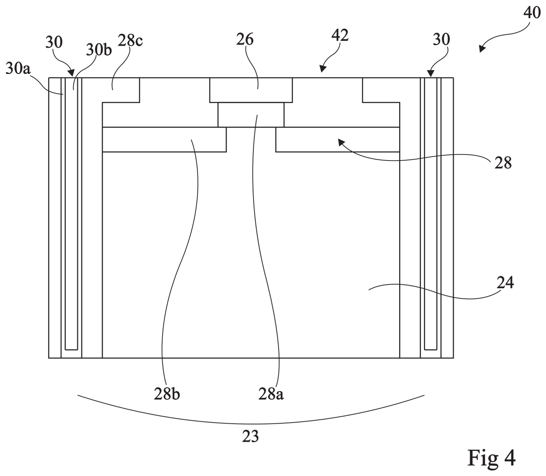

La figure 4 représente un mode de réalisation d'un dispositif électronique 40 comprenant une diode à avalanche à photon unique 42.

Le dispositif 40 comprend les éléments du dispositif 20 de la figure 2, comme décrits en relation avec la figure 2. Le dispositif 40 comprend :
le pixel 23 ;
le substrat 24 ;
la cathode 26 ;
l'anode 28, comprenant les régions 28a, 28b et 28c ; et
le mur 30, comprenant une gaine 30a et un cœur 30b.

Le dispositif 40 diffère du dispositif 20 en ce que le dispositif 40 ne comprend pas la région 27 séparant la cathode 26 et la région 28a. La cathode 26 et la région 28a forment ainsi une jonction PN.

Un avantage du mode de réalisation décrit est que la probabilité de claquage de la SPAD est maximisée. En d'autres termes, la SPAD est avantageusement plus susceptible de déclencher une avalanche à la réception d'un photon.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Dispositif électronique comprenant une diode à avalanche à photon unique (22), la diode à avalanche à photon unique (22) comprenant une jonction PN, la jonction PN ayant une première dimension inférieure à 1,2 µm, la diode à avalanche à photon unique (22) étant entourée d'un mur isolant (30), la première dimension étant la plus petite dimension de la jonction.

2. Procédé de fabrication d'un dispositif électronique comprenant une diode à avalanche à photon unique (22), la diode à avalanche à photon unique (22) comprenant une jonction PN, le procédé comprenant une étape de dopage pour fabriquer au moins une partie de l'anode de la diode à avalanche à photon unique (22), la jonction PN ayant une première dimension inférieure à 1,2 µm, la diode à avalanche à photon unique (22) étant entourée d'un mur isolant (30), la première dimension étant la plus petite dimension de la jonction.

3. Dispositif selon la revendication 1 ou procédé selon la revendication 2, dans lequel le mur isolant (30) comprend un coeur conducteur (30b) et une gaine isolante (30a).

4. Dispositif selon la revendication 1 ou 3 ou procédé selon la revendication 2 ou 3, dans lequel la cathode (26) de la diode à avalanche à photon unique (22) comprend une région dopée N située dans un substrat (24), l'anode de la diode à avalanche à photon unique (22) comprenant :
- une première partie (28a) située à l'aplomb de la cathode ; et
- une deuxième partie (28b) entourant une région du substrat (24), ladite région du substrat (24) étant séparée de la cathode par la première partie (28a).

5. Dispositif ou procédé selon la revendication 4, dans lequel la jonction PN est formée par la première partie (28a) de l'anode, la cathode (26) et la portion (27) du substrat située entre la première partie (28a) de l'anode et la cathode (26).

6. Dispositif ou procédé selon la revendication 4 ou 5, dans lequel une deuxième dimension est inférieure à 0,5 µm, la deuxième dimension étant la plus petite dimension du chevauchement entre la première partie (28a) et la deuxième partie (28b).

7. Dispositif selon l'une quelconque des revendications 1, 3 à 6 ou procédé selon l'une quelconque des revendications 2 à 6, dans lequel la première dimension est inférieure à 150 %, par exemple inférieure à 130 %, de la résolution spatiale latérale du procédé de dopage utilisé pour former au moins une partie de l'anode (28a) de la diode à avalanche à photon unique (22).

8. Dispositif ou procédé selon la revendication 7, dans lequel le procédé de dopage utilisé est une implantation ionique d'éléments dopants.

9. Dispositif selon l'une quelconque des revendications 1, 3 à 8 ou procédé selon l'une quelconque des revendications 2 à 8, dans lequel la première dimension est supérieure à 90 % de la résolution spatiale latérale du procédé de dopage.

10. Dispositif ou procédé selon l'une quelconque des revendications 6 à 9, dans lequel la résolution spatiale latérale d'un procédé de dopage est, pendant le dopage d'une région ayant la forme d'un parallélépipède rectangle, la plus petite valeur de la plus petite dimension de la face supérieure de la région permettant à la face supérieure de la région d'être plane.

11. Dispositif selon l'une quelconque des revendications 1, 3 à 10 ou procédé selon l'une quelconque des revendications 2 à 10, dans lequel la première dimension est inférieure à 1 µm.

12. Dispositif selon l'une quelconque des revendications 1, 3 à 10 ou procédé selon l'une quelconque des revendications 2 à 10, dans lequel la première dimension est comprise entre 0,7 µm et 1,2 µm.

13. Dispositif selon l'une quelconque des revendications 1, 3 à 12 ou procédé selon l'une quelconque des revendications 2 à 12, dans lequel le dispositif comprend un dispositif à temps de vol, la diode à avalanche à photon unique (22) faisant partie du dispositif à temps de vol.

14. Procédé selon l'une quelconque des revendications 2 à 13, dans lequel le procédé comprend la formation d'un masque dur, le masque dur comprenant une ouverture, au moins une des dimensions de l'ouverture étant inférieure à 150 % de la résolution spatiale latérale du procédé de dopage.

15. Procédé selon l'une quelconque des revendications 2 à 14, dans lequel le dopage est effectué à partir de la face la plus proche de la cathode.
